(19) Europäisches Patentamt
European Patent Office
Office européen des brevets

(11) **EP 0 977 284 B1**

(12) **EUROPÄISCHE PATENTSCHRIFT**

(45) Veröffentlichungstag und Bekanntmachung des
Hinweises auf die Patenterteilung:
**26.10.2005 Patentblatt 2005/43**

(51) Int Cl.7: **H01L 41/083**

(21) Anmeldenummer: **99113245.7**

(22) Anmeldetag: **06.07.1999**

(54) **Vielschicht-Piezoaktor**

Multilayer piezoelectric actuator

Organe d'actionnement piezoélectrique multicouches

(84) Benannte Vertragsstaaten:
**DE FR IT**

(30) Priorität: **30.07.1998 DE 19834461**

(43) Veröffentlichungstag der Anmeldung:
**02.02.2000 Patentblatt 2000/05**

(73) Patentinhaber: **SIEMENS
AKTIENGESELLSCHAFT
80333 München (DE)**

(72) Erfinder:
• **Kappel, Andreas, Dr.
85649 Brunnthal (DE)**
• **Mock, Randolf, Dr.
81739 München (DE)**
• **Meixner, Hans, Prof.-Dr.
85540 Haar (DE)**

(56) Entgegenhaltungen:
**WO-A-97/36365**

**Beschreibung**

Die Erfindung betrifft einen auf einem piezoelektrischen Wirkprinzip basierenden Vielschicht-Aktor und ein Verfahren zur Herstellung desselben.

Zur Auslösung eines schnellen Stellvorgangs wird in zunehmendem Maße ein Vielschicht-Piezoaktor (PMA = Piezoelektrischer Multilayer-Aktor) eingesetzt. Ein derartiger Aktor ist bisher aus herstellungstechnischen Gründen ausschließlich mit rechteckförmiger oder quadratischer Querschnittsgeometrie verfügbar. Im Hinblick auf eine Miniaturisierung der Komponenten ist man bemüht, den zur Verfügung stehenden Bauraum optimal zu nutzen. Da durch die Plazierung eines quadratischen Vielschicht-Piezoaktors in einem zylindrischen Gehäuse die Querschnittsfläche des Gehäuses nur zu 63,7 % genutzt wird, erreichen auch die Werte für die elektromechanisch wichtigen Eigenschaften eines solchen Vielschichtelementes, wie

die Steifigkeit $c_p = (^A/_L)\ E_M$ [N/m],

mit A = Querschnittsfläche [m$^2$], L = Aktorlänge [m], $E_M$ = Elastizitätsmodul [GPa],

und die Blockierkraft $F_B = A\ E_M\ d_{33}\ E_F$[N],

mit $d_{33}$ = Piezomodul [m/V], $E_F$ = elektrische Feldstärke [V/m]

nur das ungefähr 0,64-fache derjenigen Werte eines in diesem Sinne optimalen zylindrischen PMAs. Ein zylindrischer PMA ist aber aus herstellungstechnischer Sicht nur äußerst aufwendig und damit unrentabel fertigbar. Beispielsweise muß zum Schleifen eines keramikähnlichen Piezoaktors eine hoher Aufwand getrieben werden, z. B mittels einer besonders teuren Diamantschleifscheibe. Unter einem keramikähnlichen Material wird eine Keramik oder ein mechanisch dieser ähnliches Material verstanden.

Da die Aktorgeometrie durch die jeweilige Anwendung festgelegt ist, ergibt sich hieraus eine Restriktion für die Querschnittsgeometrie eines zumeist verwandten zylindrischen Gehäuses, wodurch ein solches Gehäuse im Durchmesser oft unnötig groß ist. Zur Behebung oder Minimierung dieses Problems ist bisher keine praktikable Lösung bekannt.

Aus WO97/36365 ist eine Anordnung bekannt, bei der mehrere elektromechanische Elemente auf einem passiven Teil in einer kreisförmigen Anordnung liegen. Die Anordnung ist in einem als Katheter realisierten Gehäuse eingefügt sodass die Form des Katheters durch eine Ansteuerung der elektromechanischen Elemente geändert werden kann.

Die Aufgabe der vorliegenden Erfindung ist es, einen Vielschicht-Piezoaktor zur Verfügung zu stellen, dessen Querschnittsgeometrie in Bezug auf ein zylindrisches Gehäuse optimiert ist und der dennoch vergleichsweise einfach herstellbar ist. Weiterhin ist ein Verfahren zu dessen Herstellung anzugeben.

Die Lösungen werden durch die Merkmalskombinationen der Ansprüche 1 bzw. 6 beschrieben.

Die Idee der Erfindung basiert darauf, einen Vielschicht-Piezoaktor mit einer hexagonalen Querschnittsgeometrie zu verwenden.

Dadurch ergibt sich der Vorteil, daß der Füllfaktor des PMAs gegenüber einem Aktor mit quadratischer Querschnittsgeometrie um 30% auf 82,7% erhöht wird.

Zudem können zur günstigen Herstellung eines hexagonalen PMAs herkömmliche, geradlinige Sägeschnitte verwendet werden. Dies zeichnet die hexagonale Grundstruktur gegenüber n-Ecken höherer Ordnung vorteilhaft aus.

Weil der Umfang eines Hexagons gegenüber dem eines Quadrates nur geringfügig zunimmt, ist der Mehraufwand für eine kostenaufwendige Nachbearbeitung der Außenflächen des PMAs vernachlässigbar.

In den folgenden Ausführungsbeispielen wird der Vielschicht-Piezoaktor schematisch näher dargestellt.

Figur 1 zeigt eine Darstellung der relevanten Querschnittsgeometrien,
Figur 2 zeigt eine Aufsicht auf einen unaufgetrennten piezoelektrischen Körper,
Figur 3a zeigt in Schrägansicht einen PMA,
Figur 3b zeigt den zu Figur 3a analogen PMA im Schnitt.

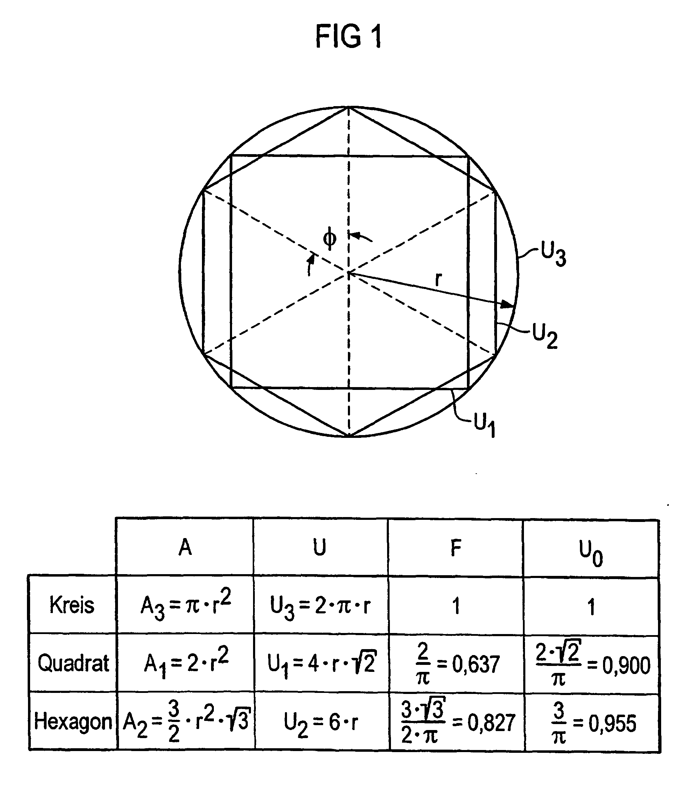

In Figur 1 ist ein Kreisumfang $U_3$ in Aufsicht dargestellt sowie die diesen Kreis ausfüllenden Umfangsgeometrien eines Quadrats $U_1$ und eines Hexagons $U_2$. Die jeweiligen gefüllten Flächen entsprechen der Querschnittsgeometrie eines Kreises, eines Quadrates bzw. eines Hexagons. Die Winkelhalbierenden des Hexagons sind gestrichelt eingezeichnet, weiterhin ist der mit $\varphi$ bezeichnete Winkel dieser Winkelhalbierenden zueinander eingezeichnet. Der Radius des Kreises, der der halben Länge der Winkelhalbierenden von Quadrat und Hexagon entspricht, ist mit r bezeichnet.

In der folgenden Tabelle ist die Beziehung zwischen Füllfläche A, Umfang U, auf den Kreis bezogenen Füllfaktor F sowie auf den Kreis bezogenen Umfang $U_0$ für Kreis, Quadrat bzw. Hexagon dargestellt.

|  | A | U | F | $U_0$ |
|---|---|---|---|---|
| Kreis | $A_3 = \pi \cdot r^2$ | $U_3 = 2 \cdot \pi \cdot r$ | 1 | 1 |
| Quadrat | $A_1 = 2 \cdot r^2$ | $U_1 = 4 \cdot r \cdot \sqrt{2}$ | $\dfrac{2}{\pi} = 0{,}637$ | $\dfrac{2 \cdot \sqrt{2}}{\pi}$ $= 0{,}900$ |
| Hexagon | $A_2 = \dfrac{3}{2} r^2 \cdot \sqrt{3}$ | $U_2 = 6 \cdot r$ | $\dfrac{3 \cdot \sqrt{3}}{2 \cdot \pi}$ $= 0827$ | $\dfrac{3}{\pi} = 0{,}955$ |

In der Tabelle ist nochmals der in Bezug auf das Quadrat erhöhte Füllfaktor F des Hexagons mit 82,7% der Fläche des Kreises erkennbar.

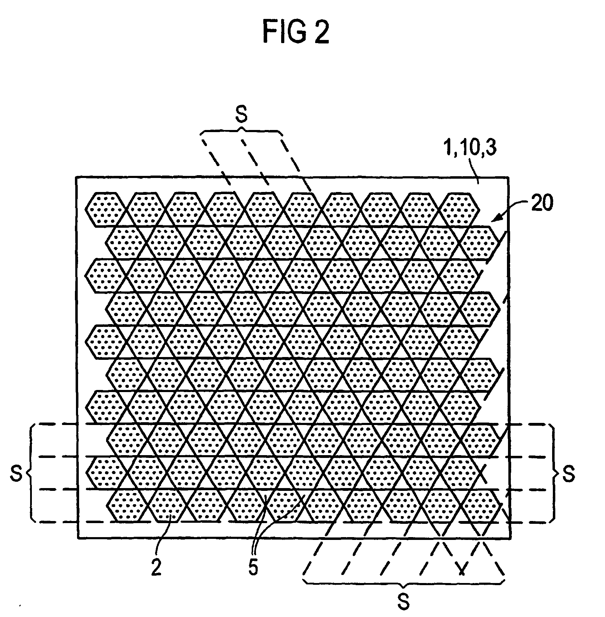

Figur 2 zeigt in Aufsicht eine mit einer Elektrodenstruktur 20 versehene Einzelschicht 1 eines PMA. Dies ist beispielsweise ein Grünteil 10, d. h. eine noch nicht gesinterte Einzelschicht oder eine schon gesinterte Schicht. Die Elektrodenstruktur 20 besteht aus mehreren hexagonalen, gleichgerichteten Elektroden 2, die sich an ihren Ecken berühren.

Zwischen den Elektroden 2, die bevorzugt aus AgPd bestehen, sind dreieckförmige Verschnittbereiche 5 erkennbar, die im einfachsten Fall nicht mit Material gefüllt sind.

Die Elektrodenstruktur 20 wird vorteilhafterweise durch Siebdruck auf der Oberseite des Grünteils 10 aufgebracht.

Das Grünteil 10 wird bevorzugt als Folie - auch Grünfolie genannt - ausgeführt. Die Grünfolie wird vorteilhafterweise mittels Folienziehen oder Foliengießen gewonnen. Es kann aber auch eine gepreßte Struktur eingesetzt werden.

Bei einem keramikähnlichen piezoelektrischen Material werden zur Herstellung eines kompakten PMAs mehrere bedruckte Grünteile 10 günstigerweise deckungsgleich aufeinandergestapelt und mittels Druck- bzw. Temperatureinwirkung gesintert. Diese werden gegebenenfalls später entbindert.

Der Siebdruckprozeß für die Elektroden 2 und die Stapelung der Grünkörper 10 erfolgen dabei vorteilhafterweise so, daß sich durch eine spätere externe Kontaktierung 6 die gewünschte Vielschichtstruktur einstellt. Somit entspricht Figur 2 auch der Aufsicht auf einen kompakten, beispielsweise schon gesinterten, piezoelektrischen Festkörper 3 oder einer schon gesinterten Einzelschicht 1.

Es ist zur vereinfachten Kontaktierung vorteilhaft, wenn die Elektrode 2 an mindestens einer Seite mindestens eine Aussparung ausweist. Dadurch können Grünteile 10 dergestalt gestapelt werden, daß die Aussparung übereinanderliegender Elektroden 2 alternierend auf einer gegenüberliegenden Seite des Hexagons angebracht ist. Durch diese Maßnahme wird vorteilhafterweise erreicht, daß nach einer Vereinzelung auf zwei entgegengesetzten Seiten eines Vielschicht-Piezoaktors nur jeweils jede zweite Elektrode an die Oberfläche reicht. Somit kann durch eine einfache elektrische Kontaktierung, beispielsweise einer flächigen Kontaktierung, die jeweils gewünschte Gruppe von Elektroden 2 angesprochen werden.

Zur Vereinzelung eines Vielschicht-Piezoaktors wird der kompakte Festkörper 3 durch mehrere geradlinige Sägeschnitte S aufgetrennt. Ein besonderer Vorteil einer hexagonalen Querschnittsgeometrie liegt darin, daß aufgrund der geradlinigen Sägeschnitte S das zur Vereinzelung der PMA bisher eingesetzte Trennsägen unverändert angewendet werden kann. Beispielsweise wird der Festkörper 3 auf einem Träger orientiert aufgespannt, der einerseits definierte Winkeldrehungen von 60° und andererseits eine translatorische Verschiebung des Schneidetisches erlaubt. Dadurch lassen sich die zur Vereinzelung nötigen Sägeschnitte S erzeugen. Der übrigbleibende Verschnitt beträgt ein Viertel der Substratfläche.

Zur Erzielung eines homogenen Aufbaus der gestapelten Grünteile 10 und zur Verminderung der beim Sinterprozeß auftretenden inneren mechanischen Deformation werden die dreieckförmigen Verschnittbereiche 5 vorzugsweise mit einem der Dicke der Elektrodenstruktur 20 entsprechenden Füllstoff ausgefüllt, beispielsweise durch Siebbedrucken dieser Verschnittbereiche 5 mit isolierten Inseln des Elektrodenmaterials.

Auf dem PMA wird eine externe Kontaktierung 6 der alternierend ausgerichteten Elektroden 2 aufgebracht, vorteilhafterweise mittels Laserlötung o. ä. von elektrischen Kontaktfahnen an den planen Außenflächen des Bauteils. Dadurch kann eine vorteilhafte, einem mehrfachen Plattenkondensator gleichende Vielschicht-Elektrodenstruktur hergestellt werden, beispielsweise einer Gruppe von Elektroden 2 mit alternierend angeordneten Aussparungen an gegenüberliegenden Seiten des PMAs.

Ein Vorteil eines Vielschicht-Piezoaktors mit hexagonaler Querschnittsgeometrie werden anhand des folgenden Rechenbeispiels weiter erläutert:

Nimmt man für den Elastizitätsmodul einer Keramik

$E_M$ = 38 [GPa] an, und für den Piezomodul $d_{33}$ = 650 * $10^{-12}$ [m/V], so folgt für einen PMA mit quadratischer Querschnittsgeometrie der Abmessung (Breite * Tiefe* Länge) 7*7*30 mm, der in einem zylindrischen Gehäuse mit 10 mm Innendurchmesser plaziert ist:

$$\text{Steifigkeit } C_P = 62 \text{ [N/}\mu\text{m], Blockierkraft } F_B = 2421 \text{ [N] bei } E_F$$

$$= 2 \text{ kV/mm]}$$

Unter den gleichen Gehäusebedingungen ergibt sich für einen hexagonalen PMA mit einer Kantenlänge des Hexagons entsprechend einem halben Innendurchmesser des Gehäuses von 5 mm:

$$\text{Steifigkeit CP} = 82 \text{[N/}\mu\text{m], Blockierkraft } F_B = 3209 \text{ [N] bei } E_F =$$

$$2 \text{[kV/mm]}$$

Die hexagonale Grundstruktur ist insofern gegenüber n-Ecken höherer Ordnung ausgezeichnet, als daß sich mit diesen n-Ecken eine Parkettierung der Oberfläche unter der Nebenbedingung, daß sich die Einzelteile später durch Trennsägen vereinzeln lassen, nicht realisieren läßt. Weil der Umfang eines Hexagons gegenüber dem eines Quadrates nur um 6% zunimmt, ist der Mehraufwand für die nachträgliche Bearbeitung der Außenflächen des PMAs vernachlässigbar.

Als piezoelektrische Materialien werden bevorzugt Perowskite (u. a. $BaTiO_3$, $SrTiO_3$ $PbTiO_3$, $CaTiO_3$, $PbZrO_3$, $Pb(Zr_{1-x}Tix)O_3$ (PZT), $KNbO_3$, $LiNbO_3$, $LiTaO_3$) eingesetzt.

Als Material der Elektrode kann jedes geeignete Metall oder eine Metallegierung eingesetzt werden, wobei Edelmetalle bevorzugt werden. Besonders bevorzugt ist AgPd.

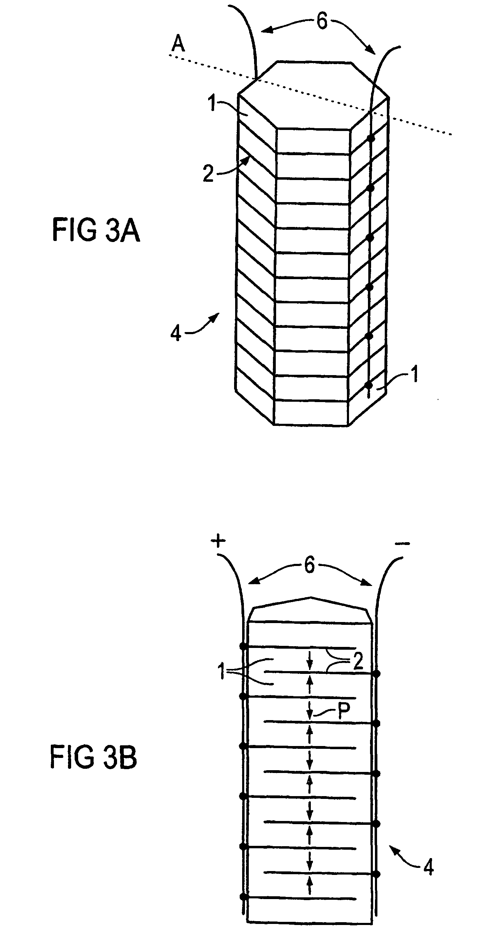

Figur 3a zeigt in Schrägansicht einen hexagonalen PMA, der aus abwechselnd aufgebrachten piezoelektrischen Einzelschichten 1 und Elektroden 2 aufgebaut ist. Die externe Kontaktierung 6 ist so ausgeführt, daß an einer externen Kontaktierung 6 jeweils jede zweite Elektrode 2 kontaktiert ist. Die gepunktet dargestellte Linie A bezeichnet den gedachten Verlauf einer Trennlinie zur Darstellung eines Schnittbildes gemäß Figur 3b.

In Figur 3b ist der zu Figur 3a analoge PMA als Schnittdarstellung entlang der Trennlinie A dargestellt. Man erkennt deutlich die alternierende Kontaktierung der Elektroden 2 in Bezug auf die externe Kontaktierung 6. Diese wird durch eine Aussparung an den Elektroden 2 erreicht, durch der Schnitt läuft.

Durch Anlegen einer elektrischen Spannung an der externen Kontaktierung 6 verhält sich diese Elektrodenstruktur wie ein Vielschicht-Kondensator. Das beim Anlegen auftretende elektrische Feld ist durch die jeweiligen Pfeile gekennzeichnet.

Durch die im Vergleich zu einer quadratischen Grundfläche erheblich bessere Annäherung an die optimale Kreisform ergibt sich zudem der weitere funktionale Vorteil, daß beispielsweise die Kraftanleitung in das anzutreibende Element homogener erfolgt, die mechanische Spannungsverteilung im Vielschichtelement ausgeglichener ist und die Feldstärke-Inhomogenität an den Ecken der Elektrodenstruktur 20 aufgrund des stumpferen Randwinkels (120° statt 90°) reduziert wird.

**Patentansprüche**

1. Piezoelektrischer Vielschichtaktor, welcher in einem zylinderförmigen Gehäuse eingepasst ist, **dadurch gekennzeichnet, daß** die Querschnittsgeometrie des aktors eine hexagonale Form aufweist.

2. Aktor nach Anspruch 1, bei dem
   mindestens eine Elektrode (2) aus AgPd besteht.

3. Aktor nach einem der vorhergehenden Ansprüche, bei dem mindestens eine piezoelektrische Einzelschicht (1) aus $PbTiO_3$, $PbZrO_3$ oder PZT besteht.

4. Aktor nach einem der vorhergehenden Ansprüche, bei dem an einer Seite einer Elektrode (2) eine Aussparung vorgesehen ist.

5. Aktor nach einem der vorhergehenden Ansprüche, bei dem durch eine abwechselnde externe Kontaktierung der Elektroden (2) eine Vielschicht-Elektrodenstruktur vorliegt, die einem mehrfachen Plattenkondensator gleicht.

6. Verfahren zur Herstellung eines piezoelektrischen Vielschicht-Aktors nach einem der Ansprüche 1 bis 5, bei dem

- ein Grünteil (10) auf seiner Oberseite mit einer Elektrodenstruktur (20) versehen wird,
- mindestens zwei Grünteile (10) übereinander gestapelt und danach zu einem kompakten Festkörper (3) verbunden werden,
- aus dem kompakten Festkörper (3) durch Trennsägen mindestens ein piezoelektrisches Vielschichtelement mit hexagonaler Querschnittsgeometrie gewonnen wird,
- das piezoelektrische Vielschichtelement in ein Gehäuse mit kreisförmigem Querschnitt eingeführt wird.

7. Verfahren nach Anspruch 6,bei dem
die Grünteile (10) durch Sinterung zu einem kompakten Festkörper (3) verbunden werden.

8. Verfahren nach einem der Ansprüche 6 bis 7,
bei dem der Grünteil (10) mittels Foliengießen oder Folienziehen gewonnen wird.

9. Verfahren nach einem der Ansprüche 6 bis 8,
bei dem die Elektrodenstruktur (20) mittels Siebdruck auf das Grünteil (10) aufgebracht wird.

10. Verfahren nach einem der Ansprüche 6 bis 9,
bei dem die Elektroden (2) des piezoelektrischen Vielschichtelementes (4) aus dem kompakten Festkörper (3) durch parallele und um 60° gedrehte Sägeschnitte (S) vereinzelt werden.

11. Verfahren nach einem der Ansprüche 6 bis 10,
bei dem die Elektrodenstruktur (20) des Grünkörpers (10) aus einem regelmäßigen, aus mehreren hexagonalen Elektroden (2) aufgebauten Muster besteht.

12. Verfahren nach einem der Ansprüche 6 bis 11,
bei dem die Verschnittbereiche (5) mit einem der Dicke der Elektrodenstruktur (20) entsprechenden Füllstoff ausgefüllt werden.

13. Verfahren nach einem der Ansprüche 6 bis 12,
bei dem auf die planen Außenflächen des piezoelektrischen Vielschichtelementes (4) eine externe Kontaktierung (6) angebracht wird.

14. Verfahren nach Anspruch 13, bei dem an der mit einer externen Kontaktierung (6) versehenen Oberfläche in zumindest einem Teil jede zweite Elektrode (2) eine Aussparung aufweist.

15. Verfahren nach einem der Ansprüche 13 oder 14, bei dem die externe Kontaktierung (6) durch Laserlötung von elektrischen Kontaktfahnen aufgebracht wird.

## Claims

1. Piezoelectric multilayer actuator which is installed in a cylindrical package, **characterised in that** the cross-sectional geometry of the actuator has a hexagonal form.

2. Actuator according to claim 1, in which at least one electrode (2) consists of AgPd.

3. Actuator according to one of the preceding claims, in which at least one piezoelectric individual layer (1) consists of $PbTiO_3$, $PbZrO_3$ or PZT.

4. Actuator according to one of the preceding claims, in which a recess is provided on one side of an electrode (2).

5. Actuator according to one of the preceding claims, in which a multilayer electrode structure is produced by an alternate external bonding of the electrodes (2), said multilayer electrode structure being equivalent to a plate capacitor.

6. Method for producing a piezoelectric multilayer actuator according to one of the claims 1 to 5, in which

- a green part (10) has an electrode structure (20) provided on its upper side,
- at least two green parts (10) are stacked one above the other and subsequently joined to form a compact solid body (3),
- at least one piezoelectric multilayer element having a hexagonal cross-sectional geometry is obtained from the compact solid body (3) by means of dicing,
- the piezoelectric multilayer element is inserted into a package having a circular cross section.

7. Method according to claim 6, in which the green parts (10) are joined to form a compact solid body (3) by means of sintering.

8. Method according to one of claims 6 to 7, in which the green part (10) is obtained by means of film casting or film pulling.

9. Method according to one of claims 6 to 8, in which the electrode structure (20) is deposited onto the green part (10) by means of screen printing.

10. Method according to one of claims 6 to 9, in which the electrodes (2) of the piezoelectric multilayer element (4) are separated from the compact solid body (3) by means of saw cuts (S) which are parallel and rotated through 60°.

11. Method according to one of claims 6 to 10, in which the electrode structure (20) of the green body (10) consists of a regular pattern which is formed by a plurality of hexagonal electrodes (2).

12. Method according to one of claims 6 to 11, in which the intersection areas (5) are filled with a filler which corresponds to the thickness of the electrode structure (20).

13. Method according to one of the claims 6 to 12, in which an external bonding (6) is attached to the plane outer surfaces of the piezoelectric multilayer element (4).

14. Method according to claim 13, in which every second electrode (2) has a recess in at least a part of the surface which is provided with an external bonding (6).

15. Method according to one of claims 13 or 14, in which the external bonding (6) is attached by means of laser soldering of electrical contact tags.

**Revendications**

1. Actionneur multicouches piézoélectrique qui est encastré dans un boîtier de forme cylindrique, **caractérisé en ce que** la géométrie en coupe transversale de l'actionneur présente une forme hexagonale.

2. Actionneur selon la revendication 1 dans lequel au moins une électrode (2) est en AgPd.

3. Actionneur selon l'une quelconque des revendications précédentes dans lequel au moins une couche piézoélectrique individuelle (1) est en $PbTiO_3$, $PbZrO_3$ ou PZT.

4. Actionneur selon l'une quelconque des revendications précédentes dans lequel un évidement est prévu sur un côté d'une électrode (2).

5. Actionneur selon l'une quelconque des revendications précédentes dans lequel il y a, par une mise en contact externe alternante des électrodes (2), une structure d'électrode multicouches qui ressemble à un condensateur à lames multiples.

6. Procédé pour la fabrication d'un actionneur multicouches piézoélectrique selon une des revendications 1 à 5 dans lequel

- une pièce verte (10) est pourvue d'une structure d'électrodes (20) sur sa partie supérieure,
- au moins deux pièces vertes (10) sont empilées l'une sur l'autre et sont reliées ensuite pour former un corps solide (3) compact,
- à partir du corps solide (3) compact au moins un élément multicouche piézoélectrique avec une géométrie en coupe transversale hexagonale est obtenu par sciage,
- l'élément multicouches piézoélectrique est introduit dans un boîtier ayant une coupe transversale circulaire.

7. Procédé selon la revendication 6 dans lequel les pièces vertes (10) sont reliées par frittage pour former un corps solide (3) compact.

8. Procédé selon une des revendications 6 à 7 dans lequel la pièce verte (10) est obtenue par moulage de feuille ou étirage de feuille.

9. Procédé selon une des revendications 6 à 8 dans lequel la structure d'électrodes (20) est appliquée par sérigraphie sur la pièce verte (10).

10. Procédé selon une des revendications 6 à 9 dans lequel les électrodes (2) des éléments (5) multicouches piézoélectriques sont isolées du corps solide (3) compact par des voies de scie parallèles et en biais de 60°.

11. Procédé selon une des revendications 6 à 10 dans lequel la structure d'électrodes (20) du corps vert (10) est faite d'un motif régulier construit à partir de plusieurs électrodes (2) hexagonales.

12. Procédé selon une des revendications 6 à 11 dans lequel des zones découpées (5) sont remplies avec une charge correspondant à l'épaisseur de la structure d'électrode (20).

13. Procédé selon une des revendications 6 à 12 dans lequel une mise en contact (6) externe est appliquée sur les surfaces extérieures planes de l'élément multicouches (4) piézoélectrique.

14. Procédé selon la revendication 13 dans lequel, au niveau de la surface supérieure pourvue d'une mise en contact (6) externe, chaque deuxième électrode (2) comporte sur au moins une partie un évidement.

15. Procédé selon une des revendications 13 ou 14 dans lequel la mise en contact (6) externe est appliquée par soudage au laser de lamelles de contact électriques.

# FIG 1

| | A | U | F | $U_0$ |
|---|---|---|---|---|
| Kreis | $A_3 = \pi \cdot r^2$ | $U_3 = 2 \cdot \pi \cdot r$ | 1 | 1 |
| Quadrat | $A_1 = 2 \cdot r^2$ | $U_1 = 4 \cdot r \cdot \sqrt{2}$ | $\dfrac{2}{\pi} = 0{,}637$ | $\dfrac{2 \cdot \sqrt{2}}{\pi} = 0{,}900$ |
| Hexagon | $A_2 = \dfrac{3}{2} \cdot r^2 \cdot \sqrt{3}$ | $U_2 = 6 \cdot r$ | $\dfrac{3 \cdot \sqrt{3}}{2 \cdot \pi} = 0{,}827$ | $\dfrac{3}{\pi} = 0{,}955$ |

# FIG 2

EP 0 977 284 B1

FIG 3A

FIG 3B

10